# EUROPEAN PATENT APPLICATION

(11) **EP 4 711 865 A1**
(43) Date of publication of application: **18.03.2026**
(21) Application number: 24200715.1
(22) Date of filing: 17.09.2024
(51) Int. Cl.: G04F 5/14, G01C 19/62, G01N 21/03, G01R 33/26, H01S 1/06, H03L 7/26, G01N 24/00, H01S 5/0687

(54) **ATOMIC VAPOR CELL AND SENSOR DEVICE COMPRISING AN ATOMIC VAPOR CELL**

(71) Applicant: Q.ant GmbH, 70565 Stuttgart (DE)
(72) Inventor: Padniuk, Mikhail, 70599 Stuttgart (DE); Torralbo-Campo, Lara, 71083 Herrenberg (DE)
(74) Representative: DREISS Patentanwälte PartG mbB

(57) **Abstract**

The invention relates to an atomic vapor cell (2), comprising: a substrate (8) having a window (8a), the substrate (8) preferably being made of silicon, a first and a second optical component (9a, 9b) arranged on opposite sides of the substrate (8), the window (8a) in the substrate (8) together with the optical components (9a, 9b) delimiting an atomic vapor chamber (7). The second optical component (9b) has a reflective surface (12a), preferably made of silicon, configured to reflect pump light propagating within the atomic vapor chamber (7), in particular at least a portion of a laser beam (4) that enters the atomic vapor chamber (7) from the first optical component (9a). The invention also relates to a sensor device (1) comprising such an atomic vapor cell (2).

## Description

The present invention relates to an atomic vapor cell, comprising: a substrate having a window, the substrate preferably being made of silicon, a first and a second optical component arranged on opposite sides of the substrate, the window of the substrate together with the optical components delimiting an atomic vapor chamber. The invention also relates to a sensor device comprising such an atomic vapor cell.

Atomic vapor cells are the sensor core of atomic sensing instruments such as atomic gyroscopes, atomic magnetometers, atomic clocks, etc. and need to fulfill several requirements for a proper performance. For instance, at least one laser beam has to propagate through the cell to interact with the atoms (optical pumping) and also for a readout in a detector, e.g. in a photodiode. In order to vaporize atoms, e.g. alkali metal atoms, the atomic vapor chamber has to reach a uniform temperature of up to 100°C or more. A thermal stabilization of around 10 mK is typically required to achieve ultrahigh sensitivity. The heating mechanism needs to be applied in a controllable and uniform way. It is also relevant that materials and the way to apply the current for the heating shall not induce any magnetic field near the atomic vapor chamber region.

CN104229719A describes a MEMS device having an atomic vapor cell that is configured in the way indicated above and that also comprises a heating coil composed of a transparent conductive material being located at at least one of a position corresponding to the window on an upper surface of a first glass substrate and a position corresponding to the window on a lower surface of a second glass substrate. The material of the heating element shall be transparent and a solution is to coat the glass substrate with a film of Indium Tin Oxide (ITO).

CN110553635A discloses an atomic gas chamber made of glass that is heated by a transparent conductive heating film deposited on the outer surface of a transparent surface of the atomic gas chamber. The transparent conductive heating film is deposited from an indium tin oxide or an aluminum-doped zinc oxide or a fluorine-doped tin oxide semiconductor material. An alternating current is applied to the transparent conductive heating film to reduce the residual magnetic field generated by the transparent conductive heating film.

The article "Indium Tin Oxide Non-Magnetic Heating Film for Miniaturized SERF Gradient Magnetometer", Zhi Liu et al., IEEE Sensors Journal, Vol. 21, No. 15, August 1, 2021, proposes the application of a non-magnetic heating film based on indium tin oxide (ITO) in a miniaturized spin exchange relaxation free (SERF) gradient magnetometer. ITO is a transparent and electrically conductive material which can be used as resistance wire to form a heating film. The ITO film is deposited on a glass substrate by evaporation and is then patterned with photolithography and etched through reactive ion etching (RIE). A pattern of the non-magnetic heating film is optimized to reduce the magnetic noise thereof, for example in a roll-type or in a serpentine type. A volume of the miniaturized vapor cell is 10mm x 10mm x 20mm.

The article "Nanostructured Alkali-Metal Vapor Cells", T.F. Cutler et al., Phys. Rev. Applied 14, 034054, 2020, describes an all-glass alkali-metal vapor cell with nanometer-scale internal structure and a glue-free design. The vapor cell incorporates a compact integrated heating system in the form of an external deposited indium tin oxide layer. The cell is assembled from three distinct parts in the form of a cover slide, a block and a reservoir. The block is a fused silica cuboid and the cover slide comprises micro- and nanoscale features. Heating is achieved via ITO regions on external surfaces of the cell.

The article "Recent Progress on Micro-Fabricated Alkali Metal Vapor Cells", Biosensors 2022, 12, 165, Xulei Wang et al., describes bonding methods for micro-fabricated vapor cells such as glass-silicon-glass anodic bonding in order to reduce the volume of the cells to the cubic centimeter or even cubic millimeter level.

As indicated above, a laser beam has to interact with the atoms in the cell (optical pumping) and is also used for a readout in a detector. For this purpose, the laser beam typically enters the atomic vapor chamber from the first glass substrate and exits the atomic vapor chamber through the second glass substrate and is directed to the detector.

### Object of the Invention

The object of the invention is to improve an atomic vapor cell and a sensor device comprising such an atomic vapor cell.

### Subject-matter of the Invention

This object is achieved by an atomic vapor cell as described in the introduction, wherein the second optical component has at least one reflective surface, preferably made of silicon, configured to reflect pump light propagating within the atomic vapor chamber, in particular at least a portion of a laser beam that enters the atomic vapor chamber from the first optical component. The atomic vapor cell described herein is preferably microfabricated.

The laser beam that enters the atomic vapor chamber and passes through the atomic vapor chamber is used as pump light to interact with the atoms of the atomic vapor in the atomic vapor chamber. As indicated above, in conventional devices having an atomic vapor chamber, the laser beam that enters the atomic vapor chamber from the first optical component, passes through the window of the substrate and exits the atomic vapor chamber through the second optical component. In contrast thereto, in the present atomic vapor cell, the laser beam (or most of the power of the laser beam) is reflected - typically retro-reflected - at the reflective surface being used as an integrated mirror, so that the laser beam passes through the atomic vapor chamber a second time (double-pass). In this way, the optical pumping of the atoms in the atomic vapor chamber can be enhanced. It is also possible that the first optical component comprises at least one reflective surface and/or that the second optical component comprises more than one reflective surface in order to realize a multipass of the pump light in the atomic vapor chamber.

In one embodiment, the second optical component comprises a preferably planar surface that delimits the atomic vapor chamber, the surface preferably being formed on a glass substrate of the second optical component. The laser beam that enters the atomic vapor cell through the first optical component typically impinges on the planar surface of the second optical component in a direction perpendicular to the planar surface of the second optical component. In this case, when the planar surface of the second optical component that delimits the atomic vapor chamber constitutes the reflective surface, the laser beam can be retro-reflected at the reflective surface and passes through the atomic vapor cell a second time along the same propagation path.

In one development, the reflective surface is a preferably planar surface that is spaced apart from the surface of the second optical component delimiting the atomic vapor chamber, the reflective surface preferably being arranged parallel to the surface of the second optical component delimiting the atomic vapor chamber. It is preferable when the reflective surface is spaced apart from the atomic vapor chamber. When the reflective surface is arranged in parallel to the surface of the second optical component that delimits the atomic vapor chamber, a laser beam that impinges on that surface in a direction perpendicular to that surface is retro-reflected back to the first optical component.

In a further embodiment, the second optical component comprises a further substrate that is arranged on a side of the glass substrate that faces away from the surface of the second optical component delimiting the atomic vapor chamber, the further substrate being made of a reflective material, preferably of silicon. In this case, a surface of the further substrate adjacent to the glass substrate forms the reflective surface. The further substrate may be bonded, e.g. by anodic bonding, to the glass substrate, but it is also possible that the further substrate is configured as a layer that is deposited on the glass substrate, e.g. in the form of a silicon layer. The silicon substrate can be used as an integrated mirror to retro-reflect the pump laser beam to enhance the pumping of atoms in the atomic vapor chamber.

In an improvement of this embodiment, the further substrate comprises a hole configured to transmit radiation from the atomic vapor chamber, in particular a portion of the laser beam that enters the atomic vapor chamber from the first optical component. As indicated above, a portion of the laser beam that enters the atomic vapor chamber should be directed to a detector, e.g. a photodiode, for readout, typically for spectral monitoring. The hole in the further substrate allows partial transmission of pump light from the atomic vapor chamber towards the detector.

In a further embodiment, at least one of the optical components, preferably both optical components, comprise a transparent conductive heating film for heating the atomic vapor chamber. The respective transparent conductive heating film is typically applied to the external surfaces of the optical components, i.e. on the surfaces facing away from the atomic vapor chamber. The transparent conductive heating film is transparent for the wavelength of the pump light, i.e. of the laser beam. For this reason, the laser beam can pass through the conductive heating films on both optical components. The transparent conductive heating films allow to provide integrated heating of the atomic vapor cell. In this way, a fully integrated and compact atomic vapor cell can be realized, by both integrating the mirror and the heating into the atomic vapor cell, without the need for additional components such as an external mirror. The transparent conductive heating films preferably cover the full surface of the optical component to which they are applied (typically with the exception of the hole). The atomic vapor cell having the transparent heating film(s) forms a micro-electromechanical system.

In a preferred development of this embodiment, the transparent conductive heating film is an indium tin oxide film. The indium tin oxide film is configured as a thin film coating that combines indium oxide (In₂O₃) and tin oxide (SnO₂) deposited on a surface of the respective optical component, e.g. on the further substrate of the second optical component and/or on the glass substrate of the first optical component. Indium tin oxide has high resistivity, is electrically conductive, has low power consumption (e.g. less than 1 W) and is transparent to the wavelength(s) of the pump light, i.e. of the laser beam that passes through the atomic vapor chamber, so that light can go through it while using the full cell as a resistor element.

It will be understood that the heating of the atomic vapor cell may be performed by other heating methods, e.g. by using a resistance Pt integrated wire loop, ovens with AC heating, laser-heating, flexible resistive foil heaters, a TCO (transparent conductive oxide) other than ITO, LTCC (low temperature cofired ceramics), etc., but heating using an ITO film (more precisely, two ITO films) is preferred.

In a further embodiment, the transparent conductive heating film has a thickness of 300 nm or less, preferably of 250 nm or less, in particular of 200 nm or less. A transparent conductive heating film having a small thickness is typically sufficient to provide heating of the atomic vapor cell, in particular when indium tin oxide is used as the material of the transparent conductive heating film.

In a further embodiment, the transparent conductive heating film is patterned, preferably in a meander pattern. Patterning of the transparent conductive heating film in a certain geometry pattern is advantageous to avoid the current provided for the heating to induce extra magnetic fields for non-magnetic heating. Other heating methods, e.g. the heating methods mentioned above, should also fulfill this requirement. Photolithograhpy is typically used to imprint a meander pattern on the transparent conductive heating film. Details of the patterning of the transparent conductive heating film in the form of an ITO film are described e.g. in the article by Zhi Liu et al. cited above, the entire contents of which are incorporated by reference into the present application.

In a preferred embodiment, the atomic vapor cell is configured to drive the transparent conductive heating film with an alternating current. For this purpose, the atomic vapor cell comprises electrodes and/or wires that are connected to the transparent conductive heating film to apply a current from an AC current driver. The combination of the AC heating and the shape pattern of the transparent conductive heating film allows for a second-order cancellation of induced magnetic fields.

In a further embodiment, the substrate and the optical components are connected by bonding, preferably by anodic bonding. The integrated atomic vapor cell is preferably fabricated using anodic bonding of the optical components, typically of the glass substrates thereof, with the substrate that comprises the window. It will be understood that other fabrication methods may be used as well, as described e.g. in the article by T.F. Cutler et al. cited above, the entire contents of which are incorporated into this application by reference. As described above, the further substrate, e.g. of silicon, may also be bonded, in particular anodically bonded, to the glass substrate of the second optical component.

The first and the second component are preferably configured as plate shaped components having two parallel surfaces, one of which is bonded or connected to the substrate comprising the window. The other, external surface typically comprises the transparent conductive heating film. The substrate is typically sandwiched between the two optical components.

The atomic vapor chamber of the atomic vapor cell is completely (hermetically) sealed. When the atomic vapor chamber is sealed, it comprises an atomic vapor, e.g. an atomic vapor in the form of at least one noble gas, preferably containing Rb and Xe atoms.

A further aspect of the invention relates to a sensor device, comprising an atomic vapor cell as described above. The sensor device may be configured as an atomic gyroscope, an atomic clock, an atomic magnetometer, etc.

In one embodiment, the sensor device further comprises: a laser configured to direct a laser beam into the atomic vapor chamber through the first optical component, the laser beam preferably propagating in a direction perpendicular to the surface of the second optical component delimiting the atomic vapor chamber. When the reflective surface is arranged perpendicular to the laser beam that enters into the atomic vapor chamber, the laser beam can be retro-reflected back through the atomic vapor chamber, increasing the atom-laser interaction in the cell.

In a further embodiment, the sensor device comprises a detector for detecting the portion of the laser beam that is transmitted through the hole of the further substrate. The detector, e.g. a photodiode, may be used to perform monitoring of an absorption spectrum of the cell.

In a further embodiment, the sensor device is configured to reflect a portion of more than 30%, preferably of more than 50% of the laser beam at the reflective surface. For this purpose, the beam diameter and/or the alignment of the laser beam is adapted to the diameter and/or the position of the hole in the further substrate that transmits part of the laser beam.

Further advantages of the invention may be found in the description and the drawing. Likewise, the features mentioned above and those referred to below may be used independently, or several of them may be used in any desired combinations. The embodiments shown and described are not to be interpreted as an exhaustive list, but rather have an exemplary nature for description of the invention.

In the figures:

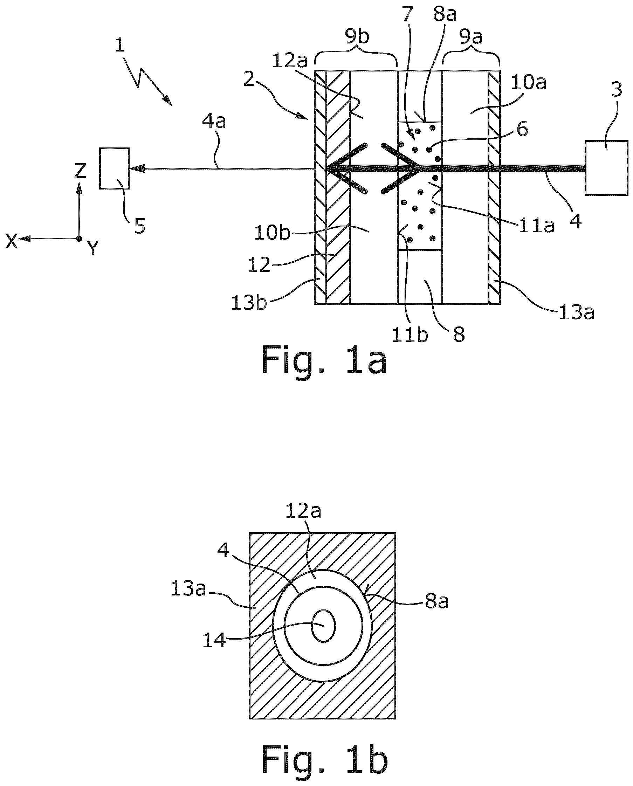

- Figure 1a: shows a schematic representation of a sensor device with an atomic vapor cell in a longitudinal section, and
- Figure 1b: shows a schematic representation of a top view of the atomic vapor cell of Figure 1a.

In the following description of the drawings, identical reference signs are used for components which are the same or functionally equivalent.

**Figure 1a** shows a sensor device 1 that is configured as a nuclear magnetic resonance gyroscope. The sensor device 1 comprises an atomic vapor cell 2, a laser 3 for generating a laser beam 4 and a detector 5 in the form of a photodiode. The laser beam 4 is used as pump light for optical pumping of an atomic vapor 6 that is arranged in an atomic vapor chamber 7 of the atomic vapor cell 2. In the present example, the atomic vapor 6 is a mixture of Rb and Xe. The sensor device 1 comprises further components that are not shown in the figures.

The atomic vapor cell 2 comprises a substrate 8 made of silicon that has a window 8a in the form of a cylindrically shaped through-hole. The substrate 8 is sandwiched between two optical components 9a, 9b arranged on opposite sides of the substrate 8. The window 8a in the substrate 8 together with the optical components 9a, 9b delimits an atomic vapor chamber 7. The substrate 8 and the two optical components 9a, 9b are connected to each other by anodic bonding.

In the present example, the atomic vapor chamber 7 containing the atomic vapor 6 is hermetically sealed.

Both the first and the second optical components 9a, 9b comprise a glass substrate 10a, 10b configured as a plane-parallel plate. Both the first and the second glass substrate 10a, 10b comprise a planar surface 11a, 11b that delimits the atomic vapor chamber 7. The planar surfaces 11a, 11b delimiting the atomic vapor chamber 7 are arranged parallel to each other and perpendicular to a propagation direction of the laser beam 4.

The second optical component 9b comprises a further substrate 12 made from silicon that is arranged on a side of the glass substrate 10b of the second optical component 9b that faces away from the surface 11b delimiting the atomic vapor chamber 7. The further substrate 12 is anodically bonded to the glass substrate 10b of the second optical component 9b. The silicon material of the further substrate 12 is reflective for the wavelength of the laser beam 4. For this reason, a planar surface 12a of the further substrate 12 adjacent to the glass substrate 10b of the second optical component 9b forms a reflective surface for pump light propagating within the atomic vapor chamber 7. The reflective surface 12a is spaced apart from the surface 11b of the second optical component 9b delimiting the atomic vapor chamber 7. The reflective surface 12a is also arranged in parallel to the surface 11b of the second optical component 9b delimiting the atomic vapor chamber 7.

Both the first and the second optical component 9a, 9b comprise a transparent conductive heating film 13a, 13b for heating the atomic vapor chamber 7. The transparent conductive heating film 13a of the first optical component 9a is applied to a planar external surface of the first optical component 9a, more precisely of the glass substrate 10a thereof. In a similar manner, the second transparent conductive heating film 13b is applied to a planar external surface of the second optical component 9b, more precisely of the further substrate 12 thereof. It is also possible that the second optical component 9b comprises an additional - typically thin - glass substrate that is applied to the further substrate 12 made from silicon at the opposite side of the reflective surface 12a. In this case, the second transparent conductive heating film 13b is applied to the external planar surface of the additional glass substrate.

In the present example, the transparent conductive heating films 13a, 13b are indium tin oxide (ITO) films. The ITO films 13a, 13b have a thickness of 300 nm or less, of 250 nm or less, or of 200 nm or less. The ITO films 13a, 13b are applied by evaporation and are then patterned with photolithography and etched through reactive ion etching (RIE). The geometric pattern of the ITO films 13a, 13b (not represented in the drawings) is a meander pattern chosen to avoid introduction of an extra magnetic field caused by a current that is provided in order to heat the ITO films 13a, 13b. The current is applied by an AC driver (not shown) that is connected to the ITO films 13a, 13b via wires to drive the ITO films 13a, 13b with an AC current. The ITO films 13a, 13b allow heating of the atomic vapor chamber 7 to temperatures of more than 100°C. The heating with the ITO heating films 13a, 13b is also very stable, meaning the temperature is provided in a stable way or in other words without fluctuation and long-term drifts. Another advantage of the ITO heating films 13a, 13b is that they are very robust and resilient to degradation while they can be heated to high temperatures.

The atomic vapor cell 2 is configured to provide a double-pass of the laser beam 4 through the atomic vapor chamber 7 to increase the optical pumping of the atomic vapor 6. For this purpose, the atomic vapor cell 2 comprises the reflective surface 12a. The laser beam 4 emitted by the laser 3 propagates in an X direction of an XYZ coordinate system and enters the atomic vapor chamber 7 of the atomic vapor cell 2 via the first optical component 9a, i.e. the laser beam 4 passes both the first transparent ITO film 13a and the first glass substrate 10a of the first optical component 9a. The laser beam 4 then impinges on the second glass substrate 10b of the second optical component 9b and is transmitted by the transparent glass substrate 10b to the reflective surface 12a of the further substrate 12 of silicon. In the present example a portion of more than 30% or 50% of the power of the laser beam 4 that impinges on the reflective surface 12a is retro-reflected and passes the atomic vapor chamber 7 a second time.

As can be gathered from **Figure 1b****,** the further substrate 12 comprises a hole 14 that allows to transmit a portion 4a of the laser beam 4 that is not reflected at the reflective surface 12a. The transmitted portion 4a of the laser beam 4 is directed to the detector 5 in the form of a photodiode for detecting an absorption spectrum of the atomic vapor 6 in the atomic vapor chamber 7. The diameter of the hole 13 is much smaller than the diameter of the laser beam 4 and also the diameter of the window 8 in the substrate 8. As can also be gathered from Figure 1b, the laser beam 4 passes through the center of the window 8a.

In Fig. 1b, the ITO film 13a is shown to have an aperture. However, this is not necessary, i.e. the ITO film 13a and also the ITO film 13b typically cover the entire external surfaces of the first and second optical components 9a, 9b to provide homogeneous heating of the atomic vapor chamber 7.

The atomic vapor cell 2 described above combines an increase in the optical pumping of the atoms in the atomic vapor chamber 7 due to the reflection of the laser beam 4 at the reflective surface 12a with a very stable and low power consuming heating system by the ITO films 13a, 13b.

## Claims

1. An atomic vapor cell (2), comprising:
a substrate (8) having a window (8a), the substrate (8) preferably being made of silicon,
a first and a second optical component (9a, 9b) arranged on opposite sides of the substrate (8), the window (8a) in the substrate (8) together with the optical components (9a, 9b) delimiting an atomic vapor chamber (7),
**characterized in that**
the second optical component (9b) has a reflective surface (12a), preferably made of silicon, configured to reflect pump light propagating within the atomic vapor chamber (7), in particular at least a portion of a laser beam (4) that enters the atomic vapor chamber (7) from the first optical component (9a).

2. The atomic vapor cell according to claim 1, wherein the second optical component (9b) comprises a preferably planar surface (11b) that delimits the atomic vapor chamber (7), the surface (11b) preferably being formed on a glass substrate (10b) of the second optical component (9b).

3. The atomic vapor cell according to claim 2, wherein the reflective surface (12a) is a preferably planar surface that is spaced apart from the surface (11b) of the second optical component (9b) delimiting the atomic vapor chamber (7), the reflective surface (12a) preferably being arranged in parallel to the surface (11b) of the second optical component (9b) delimiting the atomic vapor chamber (7).

4. The atomic vapor cell according to claim 3, wherein the second optical component (9b) comprises a further substrate (12) that is arranged on a side of the glass substrate (10b) that faces away from the surface (11b) of the second optical component (9b) delimiting the atomic vapor chamber (7), the further substrate (12) being made of a reflective material, preferably of silicon.

5. The atomic vapor cell according to claim 4, wherein the further substrate (12) comprises a hole (14) configured to transmit pump light from within the atomic vapor chamber (7), in particular a portion (4a) of the laser beam (4) that enters the atomic vapor chamber (7) from the first optical component (9a).

6. The atomic vapor cell according to any of the preceding claims, wherein at least one of the optical components (9a, 9b), preferably both optical components (9a, 9b), comprise a transparent conductive heating film (13a, 13b) for heating the atomic vapor chamber (7).

7. The atomic vapor cell according to claim 6, wherein the transparent conductive heating film (13a, 13b) is an indium tin oxide film.

8. The atomic vapor cell according to claim 6 or 7, wherein the transparent conductive heating film (13a, 13b) has a thickness of 300 nm or less, preferably of 250 nm or less, in particular of 200 nm or less.

9. The atomic vapor cell according to any of claims 6 to 8, wherein the transparent conductive heating film (13a, 13b) is patterned, preferably in a meander pattern.

10. The atomic vapor cell according to any of claims 6 to 9, configured to drive the conductive heating film (13a, 13b) with an alternating current.

11. The atomic vapor cell according to any of the preceding claims, wherein the substrate (8) and the optical components (9a, 9b) are connected by bonding, preferably by anodic bonding.

12. A sensor device (1), comprising an atomic vapor cell (2) according to any of the preceding claims.

13. The sensor device according to claim 12, further comprising: a laser (3) configured to direct a laser beam (4) into the atomic vapor chamber (7) through the first optical component (9a), the laser beam (4) preferably propagating in a direction perpendicular to the surface (11b) of the second optical component (9b) delimiting the atomic vapor chamber (7).

14. The sensor device according to claim 12 or 13, further comprising: a detector (5) for detecting the portion (4a) of the laser beam (4) that is transmitted through the hole (14) of the further substrate (12).

15. The sensor device according to any of claims 12 to 14, configured to reflect a portion of more than 30%, preferably of more than 50% of the power of the laser beam (4) at the reflective surface (12a).
